# EUROPEAN PATENT SPECIFICATION

(11) **EP 2 095 429 B1**
(45) Date of publication and mention of the grant of the patent: **25.03.2015**
(21) Application number: 07747010.2
(22) Date of filing: 20.06.2007
(51) Int. Cl.: H01L 31/042, H01L 31/0216, H01L 31/068, H01L 31/072

(54) **Solar cell and method for manufacturing the same**
Solarzelle und Verfahren zu ihrer Herstellung
Cellule solaire et procédé de fabrication de celle-ci

(30) Priority: 20.11.2006 KR 20060114282
(43) Date of publication of application: 02.09.2009
(73) Proprietor: LG Electronics Inc., Seoul 150-721 (KR)
(72) Inventor: LEE, Seong-Eun, Daejeon 305-340 (KR); PARK, Hyun-Jung, Daejeon 305-390 (KR)
(74) Representative: Cabinet Plasseraud
(86) International application number: PCT/KR2007/002976
(87) International publication number: WO 2008/062934

(56) References cited:
- JP-A- 5 129 277
- US-A- 4 751 191
- US-A- 5 091 018
- US-A- 6 091 021
- US-A- 6 093 882
- US-A1- 2004 081 747
- US-A1- 2006 197 096
- US-B1- 6 429 037
- US-B1- 6 461 969
- US-B2- 6 825 409

## Description

### Technical Field

The present invention relates to a solar cell and its manufacturing method, and more particularly to a solar cell having an improved anti-reflection film structure to give excellent photoelectric conversion efficiency and a method for manufacturing the same.

### Background Art

Recently, as exhaustion of existing energy resources such as petroleum and coal is estimated, interests on alternative energies for substituting them are more increased. Among the alternative energies, a solar cell is particularly spotlighted since its energy resource is sufficient and it does not cause any environmental pollution. A solar cell is classified into a solar heat cell that generates a vapor required for rotating a turbine using a solar heat, and a solar light cell that converts photons into electric energy using the properties of a semiconductor. Generally, a solar cell calls the solar light cell (hereinafter, the term 'solar cell' is used).

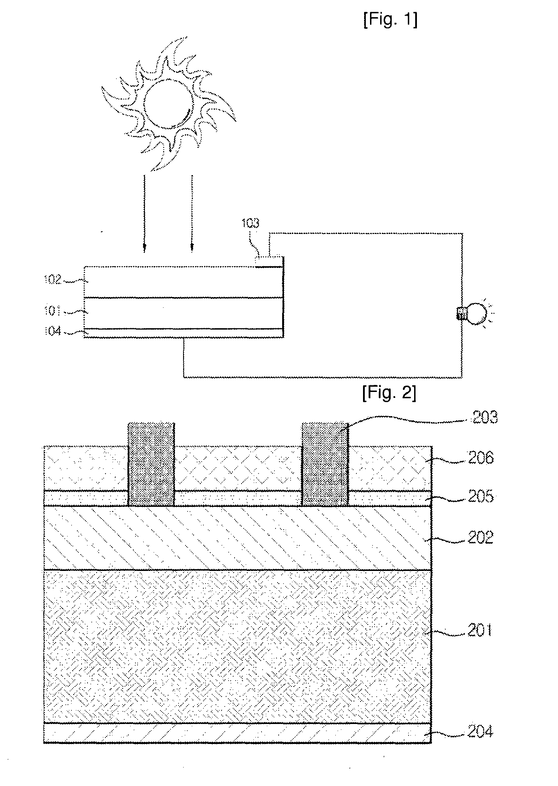

Referring to FIG. 1 showing a basic structure of a solar cell, the solar cell has a junction structure of a p-type semiconductor 101 and a n-type semiconductor 102 like a diode. If photons are input to the solar cell, the photons are reacted with materials of the semiconductor to generate electrons of (-) charge and holes of (+) charge caused by removal of the electrons, thereby allowing flow of electric current as they are moving. It is called photovoltaic effect. Among the p-type semiconductor 101 and the n-type semiconductor 102 that composes the solar cell, electrons are drawn toward the n-type semiconductor 102 and the holes are drawn toward the p-type semiconductor 101, so they are moved to electrodes 103, 104 joined to the n-type semiconductor 101 and the p-type semiconductor 102, respectively. If the electrodes 103, 104 are connected using a cable, it is possible to obtain an electric power as electricity flows.

Such output features of a solar cell are generally evaluated by measuring an output current-voltage curve using a solar simulator. On the curve, a point at which a multiplication Ip×Vp of an output current Ip and an output voltage Vp is maximum is called a maximum output Pm. Also, a value obtained by dividing Pm by a total optical energy (S×I: S is an area of an element, I is an intensity of light irradiated to the solar cell) input to the solar cell is defined as conversion efficiency η.

The efficiency η of the solar cell is determined by a short-circuit current Jsc (an output current at V=0 on the current-voltage curve), an open voltage Voc (an output voltage at I=0 on the current-voltage curve), and FF (fill factor) indicating how the output current-voltage curve is close to a square shape. Here, as FF has a value close to 1 (100%), the output current-voltage curve approximates to an ideal square shape, and the conversion efficiency h is increased.

In order to enhance the efficiency of a solar cell, it is required to increase Jsc or Voc, and makes FF (fill factor) approximate to 1 (100%). Jsc is generally increased when reflectance to the light irradiated to the solar cell is reduced, Voc is increased when the degree of recombination of carriers (electrons and holes) is reduced, and FF approximates to 1 (100%) when a resistance in the n-type and p-type semiconductors and between the semiconductors and electrodes is decreased. In this point, it would be understood that Jsc, Voc and FF, which are factors for determining the efficiency of a solar cell, are controlled by different factors.

Conventionally, reflectance of light input to a receiving side of the solar cell was decreased to increase Jsc and thus enhance efficiency of the solar cell. In order to reduce reflectance of light, there are used a method of forming an anti-reflection film to the receiving side of the solar cell to reduce reflectance of light, and a method of minimizing an area hiding photons when forming an electrode terminal in order to reduce reflectance of light. Among them, various studies on the anti-reflection film capable of realizing a low reflectance are under progress.

Recently, a method of forming an anti-reflection film composed of a silicon nitride film on an emitter at a front surface of a solar cell to reduce reflectance is developed and widely used. As an example, Korean Laid-open Patent Publication No. 2003-0079265 (hereinafter, referred to as 'a first conventional method') discloses a method of improving performance of a solar cell using a dual anti-reflection structure in which an amorphous silicon thin film and a silicon nitride film are subsequently laminated. However, the amorphous silicon thin film may attribute to increase of Voc to some extent by defect passivation of the surface of the solar cell, but it cannot cause any meaningful effect for the silicon nitride film in aspect of the reduction of reflectance that is an inherent function of the anti-reflection film. That is to say, between two factors Voc and Jsc that determines efficiency of a solar cell, the first conventional method adopts a mechanism that increases efficiency of a solar cell just by increasing Voc mainly. Thus, the first conventional method has a limit that it does not improve efficiency of a solar cell in various aspects.

As another example, US 4,649,088 (hereinafter, referred to as 'a second conventional method') discloses a method of forming an anti-reflection film by sputtering using silicon or silicon oxide film as a target to a receiving side of a solar cell, in which the anti-reflection film has a refractive index continuously reduced from the surface of the silicon substrate to the air, and the anti-reflection film has material constitutions continuously changing in the order of silicon nitride film -> silicon oxy-nitride film -> silicon oxide film so as to lower reflectance of light. The second conventional method discloses that efficiency of a solar cell may be improved by lowering reflectance of light using the anti-reflection film having the above features. However, the second conventional method fails to teach any passivation of the silicon substrate, which is another factor giving an influence on the efficiency of a solar cell. The second conventional method forms the anti-reflection film by means of sputtering, but it strongly supports the fact that the second conventional method does not have any intention to improve efficiency of a solar cell using passivation of the silicon substrate surface. If sputtering is used for forming an insulation film using silicon, it is substantially impossible to passivate the surface of a silicon substrate due to bad interface features of the insulation film. Thus, the second conventional method is considered to adopt the mechanism of improving efficiency of a solar cell by mainly increasing Jsc between two factors Voc and Jsc that determines efficiency of a solar cell. As a result, the second conventional method is similar to the first convention method in the point that it does not improve efficiency of a solar cell in various aspects.

US 4 751191 A discloses a manufacturing method for solar cells that includes a number of process steps such as diffusion, deposition, etching, etc.

JP 5 129277 A discloses a multilayer reflection preventive film which can withstand a long period of use at high humidity and temperature, using translucent glass of optional refractive index as a substrate.

### Technical Problem

The present invention is designed to solve the problems of the prior art, and therefore it is an object of the present invention to provide a solar cell having a new anti-reflection film structure capable of increasing efficiency of the solar cell in various aspects by conducting a passivation function on a substrate surface of the solar cell and a function of reducing reflectance of light at the same time.

Recently, a SiNx:H thin film grown by PECVD (Plasma Enhanced Chemical Vapor Deposition) is spotlighted as a material that can be used as an anti-reflection film of a solar cell. Here, the SiNx:H thin film means a silicon nitride film containing a large amount of hydrogen atoms, grown by PECVD under a hydrogen environment.

The anti-reflection film composed of the SiNx:H thin film is advantageously capable of playing a function of reducing reflectance of light incident onto the solar cell and a function of passivating defects on a surface of the silicon substrate by diffusion of hydrogen atoms contained in the SiNx:H thin film at the same time. In order to maximize dual functions of the anti-reflection film, it is required to precisely control refractive index and thickness of the SiNx:H thin film. Here, the refractive index of the thin film has a relatively close relation with the reduction of reflectance, while the thickness of the thin film has a relatively close relation with the passivation of the surface of the silicon substrate.

However, the inventor found that the technique of forming an anti-reflection film using the SiNx:H thin film has the following drawbacks. That is, an optimal refractive index and an optimal thickness of the SiNx:H thin film capable of minimizing reflectance of light are not identical to an optimal refractive index and an optimal thickness of the SiNx:H thin film capable of maximizing passivation of the surface of the silicon substrate. Thus, if the anti-reflection film is composed of SiNx:H thin film in one layer, it would be impossible to accomplish both functions, namely passivation of the surface of the silicon substrate and reduction of reflectance.

### Technical Solution

In order to overcome such a limitation, the inventor formed a SiNx:H thin film on a silicon substrate of a solar cell by PECVD, then formed various silicon insulation films in-situ thereon, and then analyzed Voc and Jsc of the solar cell. As a result, it was checked that both functions of the SiNx:H thin film may be realized to the maximum when a silicon oxy-nitride film was formed on the SiNx:H thin film, and also it was possible to obtain refractive index and thickness ranges of the SiNx:H thin film that allows to maximize passivation of a silicon substrate and reduction of reflectance.

More specifically, in order to accomplish the above object, there is provided a solar cell, which includes a p-n structure having a first conductive semiconductor substrate, a second conductive semiconductor layer formed on the first conductive semiconductor substrate and having a conduction opposite to the first conductive semiconductor substrate, and a p-n junction formed at an interface between the first conductive semiconductor substrate and the second conductive semiconductor layer; a first anti-reflection film formed directly on the second conductive semiconductor layer and composed of SiNx:H thin film with a thickness of 40 nm to 100 nm; a second anti-reflection film formed directly on the first anti-reflection film and composed of silicon oxy-nitride; a front electrode formed on the second anti-reflection film according to a predetermined pattern and connected to the second conductive semiconductor layer through the first and second anti-reflection films; and a rear electrode formed at an opposite side to the front electrode with the first conductive semiconductor substrate being interposed therebetween so as to be connected to the first conductive semiconductor substrate.

In another aspect of the present invention, there is also provided a method for manufacturing a solar cell, which includes (S1) forming on a first conductive semiconductor substrate a second conductive semiconductor layer having an opposite conduction thereto to form a p-n junction at an interface thereof; (S2) forming a first anti-reflection film composed of SiNx:H thin film with a thickness of 40 nm to 100 nm directly on the second conductive semiconductor layer; (S3) forming a second anti-reflection film composed of silicon oxy-nitride directly on the first anti-reflection film; (S4) forming a front electrode on the second anti-reflection film so as to be connected to the second conductive semiconductor layer; and (S5) forming a rear electrode at an opposite side to the front electrode with the first conductive semiconductor substrate being interposed therebetween so as to be connected to the first conductive semiconductor substrate.

In the solar cell and the method as provided herein, the first anti-reflection film has a refractive index of 1.5 to 3.4, the second anti-reflection film has a thickness of 10 nm to 200 nm and a refractive index of 1.45 to 2.4, and the refractive index of the first anti-reflection film is greater than that of the second anti-reflection film.

Preferably, the first and second anti-reflection films have discontinuous refractive indexes at a border interface.

Preferably, the first and second anti-reflection films are formed using an in-situ process by PECVD.

Preferably, the front electrode is formed in a way of coating a front electrode-forming paste on the second anti-reflection film into a predetermined pattern and then thermally treating the coated paste. Also, the rear electrode is preferably formed in a way of coating a rear electrode-forming paste on the first conductive semiconductor substrate into a predetermined pattern and then thermally treating the coated paste.

In the present invention, the first conductive semiconductor substrate is a p-type silicon substrate, and the second conductive semiconductor layer is a n-type emitter layer, or vice versa. A doping layer containing high density impurities (for example a p+ layer) acting as BSF (Back Surface Field) may be formed at an interface between the first conductive semiconductor substrate and the rear electrode.

### Brief Description of the Drawings

Other objects and aspects of the present invention will become apparent from the following description of embodiments with reference to the accompanying drawing in which:
FIG. 1 is a schematic view showing a basic structure of a solar cell; and
FIG. 2 is a schematic view showing a solar cell according to one embodiment of the present invention.

### Best Mode for Carrying Out the Invention

Hereinafter, a preferred embodiment of the present invention will be explained with reference to the accompanying drawing.

FIG. 2 is a schematic sectional view showing a solar cell according to one embodiment of the present invention. As shown in FIG. 2, the solar cell of the present invention includes a p-n structure, a first anti-reflection film 205, a second anti-reflection film 206, a front electrode 203 and a rear electrode 204.

The p-n structure includes a first conductive semiconductor substrate 201, a second conductive semiconductor layer 202 formed on the first conductive semiconductor substrate 201 and having an opposite conduction to the first conductive semiconductor substrate 201, and a p-n junction formed at an interface between the first conductive semiconductor substrate 201 and the second conductive semiconductor layer 202. The p-n structure receives light to generate current by means of photoelectromotive force. Representatively, the first conductive semiconductor substrate 201 is a p-type silicon substrate doped with Group 3 element such as B, Ga and In, and the second conductive semiconductor layer 202 is a n-type emitter layer doped with Group 5 element such as P, As and Sb. The p-n junction is formed by joining the p-type silicon substrate and the n-type emitter layer. As an alternative, the p-n junction may also be formed by laminating a p-type emitter layer on a n-type silicon substrate. However, the p-n structure of the present invention is not limited thereto.

On the second conductive semiconductor layer 202 having the p-n structure, the first anti-reflection film 205 composed of SiNx:H thin film and the second anti-reflection film 206 composed of silicon oxy-nitride film are subsequently formed. That is to say, the first anti-reflection film 205 is formed on the second conductive semiconductor layer 202, and the second anti-reflection film 206 is formed on the first anti-reflection film 205.

The first anti-reflection film 205 functions to passivate defects such as dangling bond existing in bulks or surface of a silicon substrate and also to reduce reflectance of light incident onto a front surface of the silicon substrate, thereby enhancing a photoelectric conversion efficiency of photons. If the defect of the silicon substrate is passivated, a recombination site of minority carrier is removed to increase Voc. Also, if the reflectance of light is decreased, an amount of light reaching the p-n junction is increased to increase Jsc. As a result, the efficiency of solar cell is improved as much as the increased amounts of Voc and Jsc.

The silicon substrate is passivated by means of hydrogen atoms included in the SiNx:H thin film that composes the first anti-reflection film 205. That is to say, hydrogen atoms are diffused toward the silicon substrate while or after the first anti-reflection film 205 is formed or during the followed thermal treatment process, thereby passivating defects in the substrate of the silicon substrate or bulks adjacent to the surface.

The second anti-reflection film 206 further reduces reflectance of light incident onto a front surface of the silicon substrate in combination with the first anti-reflection film 205. Furthermore, the second anti-reflection film 206 optimizes a refractive index range and a film thickness range of the first anti-reflection film 205 such that dual functions (passivation and reflectance reduction) of the first anti-reflection film 205 may be maximized. That is to say, when being composed only of SiNx:H thin film, the second anti-reflection film 206 solves mutual discordance between refractive index and film thickness for optimizing passivation of the silicon substrate and refractive index and thickness for minimizing reflectance of light. Accordingly, it becomes possible to suitably tune the refractive index range and the film thickness range capable of realizing dual functions of the first anti-reflection film 205.

Preferably, the first anti-reflection film 205 has a refractive index of 1.5 to 3.4 and a film thickness of 40 nm to 100 nm. If the first anti-reflection film 205 is formed under the above conditions, the dual functions of the first anti-reflection film 205 may be maximized. That is to say, due to the presence of the second anti-reflection film 206, it is possible to tune a refractive index range and a film thickness range capable of maximizing dual functions of the first anti-reflection film 205.

In relation to the numerical range for the refractive index of the first anti-reflection film 205, a refractive index less than the lower limit causes more reflection, so the first anti-reflection film 205 cannot act as an anti-reflection film. In addition, since passivation of the silicon substrate is deteriorated, the efficiency of solar cell is also deteriorated. In addition, if a refractive index exceeds the upper limit, the photoelectric efficiency is deteriorated due to the absorption of the anti-reflection film itself, undesirably. Also, in relation to the numerical range for the thickness of the first anti-reflection film 205, a thickness less than the lower limit makes the first anti-reflection film 205 unsuitable for acting as an anti-reflection film. Also, if a thickness exceeds the upper limit, light is absorbed in the anti-reflection film itself, undesirably.

Preferably, the second anti-reflection film 206 has a refractive index of 1.45 to 2.4. The refractive index of the second anti-reflection film 206 is smaller than the refractive index of the first anti-reflection film 205, but preferably the refractive index of the second anti-reflection film 206 is discontinuously decreased at a border interface based on the first anti-reflection film 205. In relation to the numerical range for the refractive index of the second anti-reflection film 206, if a refractive index is less than the lower limit, the second anti-reflection film 206 cannot be realized using silicon oxy-nitride. If a refractive index exceeds the upper limit, the photoelectric conversion efficiency is rather deteriorated due to an increased absorption of the anti-reflection film itself, undesirably.

Preferably, the second anti-reflection film 206 has a thickness of 10 nm to 200 nm. In relation to the numerical range for the thickness of the second anti-reflection film 206, if a thickness is less than the lower limit, the second anti-reflection film 206 becomes insufficient for acting as an anti-reflection film. If a thickness exceeds the upper limit, light is absorbed in the anti-reflection film itself, undesirably.

The first anti-reflection film 205 is formed by means of deposition that may include a large amount of hydrogen atoms in a silicon nitride film. Preferably, the first anti-reflection film 205 is formed using chemical deposition capable of making a hydrogen environment, more preferably using PECVD. The second anti-reflection film 206 is formed in the same way as the first anti-reflection film 205. Preferably, the first anti-reflection film 205 and the second anti-reflection film 206 are formed by means of the in-situ process using the same deposition chamber.

The front electrode 203 is formed on the first and second anti-reflection films 205, 206 in a predetermined pattern, and the front electrode 203 is connected to the second conductive semiconductor layer 202 through the first and second anti-reflection films 205, 206. In addition, the rear electrode 204 is formed at an opposite side to the front electrode 203 with the anti-reflection films 205, 206 and the first conductive semiconductor substrate 201 being interposed therebetween, so as to be connected to the first conductive semiconductor substrate 201. If loads are applied to these electrodes 203, 204, electricity generated in the solar cell can be utilized. The front electrode 203 representatively employs a silver electrode since the silver electrode has an excellent electric conductivity. Also, the rear electrode 204 representatively employs an aluminum electrode since the aluminum electrode has an excellent conductivity and allows well junction due to good affinity with silicon. In addition, the aluminum electrode corresponds to Group 3 element, which forms a p+ layer, namely BSF (Back Surface Field), at a contact surface with the silicon substrate such that carriers are not disappeared but collected, thereby enhancing efficiency of the solar cell.

The present invention also provides a method for manufacturing the solar cell explained above.

According to the method for manufacturing a solar cell of the present invention, first, on the first conductive semiconductor substrate 201, the second conductive semiconductor layer 202 having an opposite conduction thereto is formed such that a p-n junction is formed at their interface. A p-type silicon substrate is representatively used as the first conductive semiconductor substrate 201. For example, a p-type silicon substrate is coated with a n-type dopant and then thermally treated such that the n-type dopant is diffused to the p-type silicon substrate, thereby forming the p-n junction. On the contrary, it is also possible to diffuse a p-type dopant on a n-type silicon substrate to form a p-n junction.

Then, the first anti-reflection film 205 composed of SiNx:H thin film is formed on the second conductive semiconductor layer 202. The first anti-reflection film 205 is formed using chemical deposition capable of forming a hydrogen environment, preferably PECVD. Then, the second anti-reflection film 206 composed of silicon oxy-nitride film is formed on the first anti-reflection film 205. The second anti-reflection film 206 is formed in the same chemical deposition as the first anti-reflection film 205, preferably PECVD. The first and second anti-reflection films 205, 206 are preferably formed using the in-situ process in one deposition chamber.

Then, the front electrode 203 connected to the second conductive semiconductor layer 202 is formed on the second anti-reflection film 206, and the rear electrode 204 is formed at an opposite side to the front electrode 203 with the first conductive semiconductor substrate 201 being interposed therebetween, so as to be connected to the first conductive semiconductor substrate 201.

For example, the front electrode 203 and the second electrode 204 may be formed by coating an electrode-forming paste according to a predetermined pattern and then thermally treating it. Due to the thermal treatment, the front electrode 203 punches through the first and second anti-reflection films 205, 206 and connects to the second conductive semiconductor layer 202, and BSF is formed in the rear electrode and the first conductive semiconductor substrate 201. The front electrode 203 and the second electrode 204 may be formed in a reverse order, and also they may be formed by coating paste separately and then thermally treating at the same time.

### Mode for the Invention

Hereinafter, the present invention will be explained in more detail using an experimental example. However, it should be understood that the following examples may be modified in various ways, and the scope of the invention should not be limited to the following examples. The following examples are just for better understanding of the present invention to those having ordinary skill in the art.

### Experimental Example 1

A solar cell having a dual anti-reflection film structure as shown in FIG. 2 was prepared. At this time, a p-type polycrystalline silicon substrate (0.5 to 2 Ω) with a size of 125×25 cm² was used as a semiconductor substrate, and a n+ emitter layer was formed in 60 Ω/sheet. A first anti-reflection film (refractive index: 2.2, thickness: 55 nm) composed of SiNx:H thin film was formed on the emitter layer using Remote MW Frequency (2.45 GHz) PECVD, and a second anti-reflection film (refractive index: 1.57, thickness: 100 nm) composed of silicon oxy-nitride was formed on the first anti-reflection film using Direct High Frequency (13.56 MHz) PECVD. Deposition temperatures for the first and second anti-reflection films were 400°C and 350°C, respectively. After that, a silver electrode pattern was printed on the second anti-reflection film by means of screen printing, an aluminum electrode was printed on a side of the semiconductor substrate opposite to the surface where the emitter layer was formed, by means of screen printing, and then they were thermally treated for 30 seconds at 800°C to form a front electrode and a rear electrode.

### Comparative Example 1

A solar cell having a single anti-reflection film structure composed of SiNx:H thin film was prepared. At this time, a p-type polycrystalline silicon substrate (0.5 to 2 Ω) with a size of 125x25 cm² was used as a semiconductor substrate, and a n+ emitter layer was formed in 60 Ω/sheet. An anti-reflection film (refractive index: 2.03, thickness: 75 nm) composed of SiNx:H thin film was formed on the emitter layer using Remote MW Frequency (2.34 GHz) PECVD, in a single layer. Deposition temperature for the anti-reflection film was 400°C. After that, a silver electrode pattern was printed on the anti-reflection film by means of screen printing, an aluminum electrode was printed on a side of the semiconductor substrate opposite to the surface where the emitter layer was formed, by means of screen printing, and then they were thermally treated for 30 seconds at 800°C to form a front electrode and a rear electrode.

### Comparative Example 2

A solar cell was prepared in the same way as the experimental example 1. However, though the first anti-reflection film composed of SiNx:H and the second anti-reflection film composed of silicon oxy-nitride have the same refractive indexes as them of the experimental example 1, each anti-reflection film has a thickness selected less than a lower limit of the numerical range proposed in the present invention. That is to say, the first anti-reflection film has a thickness of 100 nm, and the second anti-reflection film has a thickness of 30 nm.

### Measurement of Parameters and Efficiency of Solar Cell

Short-circuit current Jsc, open voltage Voc, FF (Fill Factor) and photoelectric conversion efficiency of each solar cell prepared by the experimental example 1 and the comparative examples 1 and 2 were measured using a solar simulator. The measurement results are listed in the following table 1.

**Table 1**

| | Short-circuit Current (mA) | Open Voltage (mV) | FF (%) | Photoelectric Conversion Efficiency (%) |
|---|---|---|---|---|
| Experimental Example 1 | 33.3 | 619.7 | 78.2 | 16.1 |
| Comparative Example 1 | 32.6 | 617.5 | 77.5 | 15.6 |
| Comparative Example 2 | 32.1 | 615.5 | 75.5 | 14.0 |

Comparing the experimental example 1 with the comparative example 1, it would be found that Voc, Jsc and FF are all increased to improve photoelectric conversion efficiency in case an anti-reflection film is composed in a dual-layer structure, rather than the case that the anti-reflection film is composed in a single-layer structure. From it, it would be understood that laminating a silicon oxy-nitride film on the SiNx:H thin film may further lower reflectance of light and also give better effect on passivation of a silicon substrate. As a result, the solar cell of the experimental example 1 shows about 0.5% higher efficiency than the solar cell of the comparative example 1.

Meanwhile, based on the single layer, as the SiNx:H thin film is thicker, an amount of hydrogen atoms included in the thin film is increased, so the passivation effect of the silicon substrate is enhanced to increase Voc greater. However, if the thickness of the SiNx:H thin film is increased, there is an adverse effect on the reduction of reflectance. In the solar cell of the comparative example 1, a thickness of the SiNx:H thin film participating in passivation of the silicon substrate is about 5 nm thicker than that of the solar cell of the experimental example 1. However, seeing the table 1, an open voltage Voc of the comparative example 1 is rather smaller than that of the solar cell of the experimental example 1. It supports the fact that, if a silicon oxy-nitride film is formed on the SiNx:H thin film to make the anti-reflection film in a dual layer structure, the laminated silicon oxy-nitride film gives a synergy effect on the passivation of the silicon substrate by the SiNx:H thin film. In addition, if the SiNx:H thin film and the silicon oxy-nitride film are laminated dually, the refractive index range and the film thickness range may be tuned such that the dual functions of the SiNx:H thin film may be all realized. Thus, it would be understood that efficiency of a solar cell is further improved due to the increased Jsc and Voc, compared with the case that the anti-reflection film is formed only using a SiNx:H thin film.

Then, comparing the experimental example 1 with the comparative example 2, if each material layer composing the dual anti-reflection film is not optimized within the numerical range proposed by the present invention, Jsc, Voc and FF are all decreased, though a refractive index of each material layer is identical. In particular, Voc and FF are more decreased than Jsc. From it, it would be understood that, if the first and second anti-reflection films composed of SiNx:H thin film are not formed within the numerical ranges supposed in the present invention, it is impossible to obtain a desired passivation effect of the silicon substrate, and also a resistance characteristic between the electrode and the substrate is deteriorated during an electrode forming process, thereby giving a bad influence on the efficiency of a solar cell. In addition, it would be found again that the refractive index range and the thickness range of the first anti-reflection film composed of SiNx:H thin film are optimal numerical ranges tuned to maximize passivation and reflectance reduction of a silicon substrate by the SiNx:H thin film on the assumption that the second anti-reflection film composed of silicon oxy-nitride film exists.

It should be understood that the terms used in the specification and the appended claims should not be construed as limited to general and dictionary meanings, but interpreted based on the meanings and concepts corresponding to technical aspects of the present invention on the basis of the principle that the inventor is allowed to define terms appropriately for the best explanation.

Therefore, the description proposed herein is just a preferable example for the purpose of illustrations only, not intended to limit the scope of the invention, so it should be understood that other equivalents and modifications could be made thereto without departing from the scope of the invention.

### Industrial Applicability

The solar cell of the present invention includes a dual anti-reflection film in which a first anti-reflection film made of SiNx:H thin film and a second anti-reflection film made of silicon oxy-nitride are subsequently laminated, so it is possible to realize passivation of a silicon substrate and reduction of reflectance of light at the same time and thus to greatly improve photoelectric conversion efficiency of the solar cell. Also, the SiNx:H thin film and the silicon oxy-nitride film may be continuously formed using an in-site process, which may reduce a manufacture cost.

## Claims

1. A solar cell, comprising:
a p-n structure having a first conductive semiconductor substrate (201), a second conductive semiconductor layer (202) formed on the first conductive semiconductor substrate and having a conduction opposite to the first conductive semiconductor substrate, and a p-n junction formed at an interface between the first conductive semiconductor substrate and the second conductive semiconductor layer;
a first anti-reflection film (205) formed directly on the second conductive semiconductor layer (202) and composed of SiNx:H thin film with a thickness of 40 nm to 100 nm;
a second anti-reflection film (206) formed directly on the first anti-reflection film (205) and composed of silicon oxy-nitride;
a front electrode (203) formed on the second anti-reflection film (206) according to a predetermined pattern and connected to the second conductive semiconductor layer (202) through the first and second anti-reflection films (205, 206); and
a rear electrode (204) formed at an opposite side to the front electrode with the first conductive semiconductor substrate being interposed therebetween so as to be connected to the first conductive semiconductor substrate,
wherein the first anti-reflection film has a refractive index of 1.5 to 3.4,
wherein the second anti-reflection film has a refractive index of 1.45 to 2.4 and a thickness of 10nm to 200 nm, and
wherein the refractive index of the first anti-reflection film is greater than the refractive index of the second anti-reflection film.

2. The solar cell according to claim 1, wherein the first and second anti-reflection films (205, 206) have discontinuous refractive indexes at a border interface.

3. The solar cell according to claim 1, wherein the first anti-reflection film (205) is formed using CVD, Chemical Vapor Deposition, or PECVD, Plasma Enhanced Chemical Vapor Deposition.

4. The solar cell according to claim 1, wherein the second anti-reflection film (206) is formed using CVD or PECVD.

5. The solar cell according to claim 1, wherein the first and second anti-reflection films (205, 206) are formed using an in-situ process by PECVD.

6. The solar cell according to claim 1, wherein the first conductive semiconductor substrate (201) is a p-type silicon substrate, and the second conductive semiconductor layer (202) is a n-type emitter layer.

7. The solar cell according to claim 1, wherein a BSF, Back Surface Field, layer containing impurities having a higher concentration than the first conductive semiconductor substrate (201) is formed at an interface between the first conductive semiconductor substrate and the rear electrode (204).

8. A method for manufacturing a solar cell, comprising:
forming on a first conductive semiconductor substrate (201) a second conductive semiconductor layer (202) having an opposite conduction thereto to form a p-n junction at an interface thereof;
forming a first anti-reflection film composed of SiNx:H thin film with a thickness of 40 nm to 100 nm directly on the second conductive semiconductor layer;
forming a second anti-reflection film composed of silicon oxy-nitride directly on the first anti-reflection film;
forming a front electrode on the second anti-reflection film so as to be connected to the second conductive semiconductor layer; and
forming a rear electrode at an opposite side to the front electrode with the first conductive semiconductor substrate being interposed therebetween so as to be connected to the first conductive semiconductor substrate,
wherein the first anti-reflection film has a refractive index of 1.5 to 3.4,
wherein the second anti-reflection film has a refractive index of 1.45 to 2.4 and a thickness of 10nm to 200 nm, and
wherein the refractive index of the first anti-reflection film is greater than the refractive index of the second anti-reflection film.

9. The method for manufacturing a solar cell according to claim 8, wherein the first and second anti-reflection films (205, 206) have discontinuous refractive indexes at a border interface.

## Patentansprüche

1. Solarzelle, umfassend:
eine p-n-Struktur mit einem ersten leitfähigen Halbleitersubstrat (201), einer auf dem ersten leitfähigen Halbleitersubstrat ausgebildeten zweiten leitfähigen Halbleiterschicht (202) mit einer Leitfähigkeit, die der des ersten leitfähigen Halbleitersubstrats entgegengesetzt ist, und einem p-n-Übergang, der an einer Schnittstelle zwischen dem ersten leitfähigen Halbleitersubstrat und der zweiten leitfähigen Halbleiterschicht ausgebildet ist;
einen ersten Antireflexionsfilm (205), der direkt auf der zweiten leitfähigen Halbleiterschicht (202) ausgebildet und aus SiNx:H-Dünnfilm mit einer Stärke von 40 nm bis 100 nm zusammengesetzt ist;
einen zweiten Antireflexionsfilm (206), der direkt auf dem ersten Antireflexionsfilm (205) ausgebildet und aus Siliziumoxinitrid zusammengesetzt ist;
eine vordere Elektrode (203), die nach einem bestimmten Muster auf dem zweiten Antireflexionsfilm (206) ausgebildet und durch den ersten und den zweiten Antireflexionsfilm (205, 206) mit der zweiten leitfähigen Halbleiterschicht (202) verbunden ist; und
eine hintere Elektrode (204), die an einer der vorderen Elektrode entgegengesetzten Seite ausgebildet ist, wobei das erste leitfähige Halbleitersubstrat so dazwischen angeordnet ist, dass sie mit dem ersten leitfähigen Halbleitersubstrat verbunden ist,
wobei der erste Antireflexionsfilm einen Brechungsindex von 1,5 bis 3,4 aufweist,
wobei der zweite Antireflexionsfilm einen Brechungsindex von 1,45 bis 2,4 und eine Stärke von 10 nm bis 200 nm aufweist und
wobei der Brechungsindex des ersten Antireflexionsfilms größer als der Brechungsindex des zweiten Antireflexionsfilms ist.

2. Solarzelle nach Anspruch 1, wobei der erste und der zweite Antireflexionsfilm (205, 206) an einer Grenzschnittstelle diskontinuierliche Brechungsindizes aufweisen.

3. Solarzelle nach Anspruch 1, wobei der ersten Antireflexionsfilm (205) mittels chemischer Gasphasenabscheidung (Chemical Vapor Deposition, CVD) oder plasmaunterstützter chemischer Gasphasenabscheidung (Plasma Enhanced Chemical Vapor Deposition, PECVD) ausgebildet ist.

4. Solarzelle nach Anspruch 1, wobei der zweite Antireflexionsfilm (206) mittels CVD oder PECVD ausgebildet ist.

5. Solarzelle nach Anspruch 1, wobei der erste und der zweite Antireflexionsfilm (205, 206) mittels eines in-situ-Verfahrens durch PECVD ausgebildet sind.

6. Solarzelle nach Anspruch 1, wobei das erste leitfähige Halbleitersubstrat (201) ein p-leitendes Siliziumsubstrat ist und die zweite leitfähige Halbleiterschicht (202) eine n-leitende Emitterschicht ist.

7. Solarzelle nach Anspruch 1, wobei an einer Schnittstelle zwischen dem ersten leitfähigen Halbleitersubstrat und der hinteren Elektrode (204) eine Rückseitenfeldschicht (Back Surface Field- bzw. BSF-Schicht) ausgebildet ist, die Verunreinigungen beinhaltet, welche eine höhere Konzentration als das erste leitfähige Halbleitersubstrat (201) aufweisen.

8. Verfahren zur Herstellung einer Solarzelle, umfassend:
das Ausbilden einer zweiten leitfähigen Halbleiterschicht (202) auf einem ersten leitfähigen Halbleitersubstrat (201), mit einer diesem entgegengesetzten Leitfähigkeit, um an einer Schnittstelle derselben einen p-n-Übergang auszubilden;
das Ausbilden eines aus SiNx:H-Dünnfilm mit einer Stärke von 40 nm bis 100 nm zusammengesetzten ersten Antireflexionsfilms direkt auf der zweiten leitfähigen Halbleiterschicht;
das Ausbilden eines aus Siliziumoxinitrid zusammengesetzten zweiten Antireflexionsfilms direkt auf dem ersten Antireflexionsfilm;
das Ausbilden einer vorderen Elektrode auf dem zweiten Antireflexionsfilm, so dass sie mit der zweiten leitfähigen Halbleiterschicht verbunden ist; und
das Ausbilden einer hinteren Elektrode an einer der vorderen Elektrode entgegengesetzten Seite, wobei das erste leitfähige Halbleitersubstrat so dazwischen angeordnet ist, dass sie mit dem ersten leitfähigen Halbleitersubstrat verbunden ist,
wobei der erste Antireflexionsfilm einen Brechungsindex von 1,5 bis 3,4 aufweist,
wobei der zweite Antireflexionsfilm einen Brechungsindex von 1,45 bis 2,4 und eine Stärke von 10 nm bis 200 nm aufweist und
wobei der Brechungsindex des ersten Antireflexionsfilms größer als der Brechungsindex des zweiten Antireflexionsfilms ist.

9. Verfahren zur Herstellung einer Solarzelle nach Anspruch 8, wobei der erste und der zweite Antireflexionsfilm (205, 206) an einer Grenzschnittstelle diskontinuierliche Brechungsindizes aufweisen.

## Revendications

1. Cellule solaire, comprenant :
une structure p-n ayant un premier substrat semi-conducteur à conduction (201), une seconde couche semi-conductrice à conduction (202) formée sur le premier substrat semi-conducteur à conduction et ayant une conduction opposée à celle du premier substrat semi-conducteur à conduction, et une jonction p-n formée au niveau d'une interface entre le premier substrat semi-conducteur à conduction et la seconde couche semi-conductrice à conduction ;
un premier film anti-réfléchissant (205) formé directement sur la seconde couche semi-conductrice à conduction (202) et composé d'une couche mince de SiNx:H ayant une épaisseur de 40 nm à 100 nm ;
un second film anti-réfléchissant (206) formé directement sur le premier film anti-réfléchissant (205) et composé d'oxynitrure de silicium ;
une électrode avant (203) formée sur le second film anti-réfléchissant (206) selon un motif prédéterminé et connectée à la seconde couche semi-conductrice à conduction (202) par l'intermédiaire du premier et du second film anti-réfléchissant (205, 206) ; et
une électrode arrière (204) formée sur un côté opposé à l'électrode avant avec le premier substrat semi-conducteur à conduction intercalé entre elles de façon à être connectée au premier substrat semi-conducteur à conduction,
dans laquelle le premier film anti-réfléchissant présente un indice de réfraction de 1,5 à 3,4,
dans laquelle le second film anti-réfléchissant présente un indice de réfraction de 1,45 à 2,4 et une épaisseur de 10 nm à 200 nm, et
dans laquelle l'indice de réfraction du premier film anti-réfléchissant est supérieur à l'indice de réfraction du second film anti-réfléchissant.

2. Cellule solaire selon la revendication 1, dans laquelle les premier et second films anti-réfléchissants (205, 206) présentent des indices de réfraction discontinus au niveau d'une interface de bordure.

3. Cellule solaire selon la revendication 1, dans laquelle le premier film anti-réfléchissant (205) est formé par CVD, dépôt chimique en phase vapeur, ou par PECVD, dépôt chimique en phase vapeur assisté par plasma.

4. Cellule solaire selon la revendication 1, dans laquelle le second film anti-réfléchissant (206) est formé par CVD ou PECVD.

5. Cellule solaire selon la revendication 1, dans laquelle les premier et second films anti-réfléchissants (205, 206) sont formés en utilisant un procédé *in situ* par PECVD.

6. Cellule solaire selon la revendication 1, dans laquelle le premier substrat semi-conducteur à conduction (201) est un substrat de silicium de type p, et la seconde couche semi-conductrice à conduction (202) est une couche d'émetteur de type n.

7. Cellule solaire selon la revendication 1, dans laquelle une couche BSF (champ électrique arrière) contenant des impuretés ayant une concentration plus élevée que le premier substrat semi-conducteur à conduction (201) est formée au niveau d'une interface entre le premier substrat semi-conducteur à conduction et l'électrode arrière (204).

8. Procédé de fabrication d'une cellule solaire, comprenant :
former, sur un premier substrat semi-conducteur à conduction (201), une seconde couche semi-conductrice à conduction (202) ayant une conduction opposée à celle du premier substrat semi-conducteur à conduction pour former une jonction p-n au niveau d'une interface de ceux-ci ;
former un premier film anti-réfléchissant composé d'une couche mince de SiNx:H ayant une épaisseur de 40 nm à 100 nm directement sur la seconde couche semi-conductrice à conduction ;
former un second film anti-réfléchissant composé d'oxynitrure de silicium directement sur le premier film anti-réfléchissant ;
former une électrode avant sur le second film anti-réfléchissant de façon à ce qu'elle soit connectée à la seconde couche semi-conductrice à conduction ; et
former une électrode arrière sur un côté opposé à l'électrode avant avec le premier substrat semi-conducteur à conduction intercalé entre elles de façon à être connectée au premier substrat semi-conducteur à conduction,
dans lequel le premier film anti-réfléchissant présente un indice de réfraction de 1,5 à 3,4,
dans lequel le second film anti-réfléchissant présente un indice de réfraction de 1,45 à 2,4 et une épaisseur de 10 nm à 200 nm, et
dans lequel l'indice de réfraction du premier film anti-réfléchissant est supérieur à l'indice de réfraction du second film anti-réfléchissant.

9. Procédé de fabrication d'une cellule solaire selon la revendication 8, dans lequel les premier et second films anti-réfléchissants (205, 206) présentent des indices de réfraction discontinus au niveau d'une interface de bordure.
